# EUROPEAN PATENT APPLICATION

(11) **EP 2 065 490 A1**
(43) Date of publication of application: **03.06.2009**
(21) Application number: 08020043.9
(22) Date of filing: 17.11.2008
(51) Int. Cl.: C30B 29/40, H01L 29/06, H01L 21/302

(54) **GaN substrate manufacturing method, GaN substrate, and semiconductor device**

(30) Priority: 20.11.2007 JP 2007300899
(71) Applicant: Sumitomo Electric Industries, Ltd., Osaka-shi, Osaka 541-0041 (JP)
(72) Inventor: Irikura, Masato, Itami-shi Hyogo 664-0016 (JP); Nakahata, Seiji, Itami-shi Hyogo 664-0016 (JP)
(74) Representative: Grünecker, Kinkeldey, Stockmair & Schwanhäusser Anwaltssozietät

(57) **Abstract**

A GaN substrate manufacturing method characterized in including a step of processing the surface of a substrate composed of a GaN single crystal into a concavely spherical form, based on differences in orientation of the crystallographic axis across the substrate surface. Processing the GaN substrate surface into a concavely spherical form reduces, in the post-process GaN substrate surface, differences in orientation of the crystallographic axis with respect to a normal. Furthermore, employing to manufacture semiconductor devices a GaN substrate in which differences in orientation of the crystallographic axis have been reduced makes it possible to uniformize in device characteristics a plurality of semiconductor devices fabricated from a single GaN substrate, which contributes to improving yields in manufacturing the semiconductor devices.

## Description

### BACKGROUND OF THE INVENTION

### Technical Field

The present invention relates to methods of manufacturing GaN substrates, to the GaN substrates, and to semiconductor devices fabricated employing the GaN substrates.

### Description of the Related Art

Conventionally in fabricating GaN-based LEDs and other microelectronic semiconductor devices, in order to enhance various device properties such as emission efficiency, single crystal GaN substrates have been used. One determinant of the properties of microelectronic semiconductor devices employing single-crystal GaN substrates is crystal misalignment along the GaN substrate surface.

When there is crystal misalignment in the surface of a GaN substrate, epitaxially growing a semiconductor layer onto the substrate results in inconsistencies in the epitaxial layer composition. If such a GaN substrate is employed to fabricate, for example, light-emitting devices, the inconsistencies in the epitaxial layer composition cause nonuniformities in emission wavelength across the substrate surface. Consequently, light-emitting devices fabricated employing such a substrate, not possessing identical emission wavelengths, are likely to have variances.

Because the occurrence of crystal misalignment GaN substrates is thus thought to influence the properties of semiconductor devices employing the GaN substrates, investigations into the causes behind, and various studies as to measures against, the occurrence of misalignment have been carried out. For example, Japanese Unexamined Pat. App. Pub. No. 2000-22212 indicates that when GaAs substrates are employed as undersubstrates to form GaN single crystal, convex bowing, due mainly to heating processes in the course of production, occurs in the GaN single crystal. This publication also indicates that polishing GaN single crystal in which bowing has occurred leads to occurrence of discrepancies, along the central and the edge portions of the GaN substrate surface, in the angle between a line normal to the crystallographic plane (a crystallographic axis), and a line normal to the GaN substrate surface, and discloses a GaN single-crystal substrate manufacturing method for averting these problems.

Factors causing the crystallographic axis of GaN crystal to deviate along the surface of a GaN substrate include, in addition to those disclosed in Pat. App. Pub. No. 2000-22212, the fact that the GaN crystal growth orientation inclines. That is, during GaN crystal formation onto an undersubstrate, the GaN crystal grows inclining in such a way as to head toward the center of the undersubstrate. A consequent problem has been that despite the GaN crystal being processed so that the crystallographic axis in the vicinity of the center of the GaN substrate coincides with the normal to the GaN substrate surface, with the crystallographic axis and the normal to the GaN substrate surface not coinciding in the proximity of the substrate edge portion, crystal misalignment occurs in the GaN substrate when considered globally.

### BRIEF SUMMARY OF THE INVENTION

An object of the present invention, brought about in view of the circumstances discussed above, is to make available GaN substrate manufacturing methods, GaN substrates, and semiconductor devices fabricated employing the GaN substrates, in which crystal misalignment across the substrate surface is minimal.

In order to achieve the above objective, a GaN substrate manufacturing method in one aspect of the present invention is characterized in having a step of processing the surface of a substrate composed of a GaN single crystal into a concavely spherical form, based on differences in orientation of the crystallographic axis across the substrate surface.

In another aspect of the present invention, a GaN substrate is characterized in being composed of single crystal, and is characterized in that the surface has been processed into a concavely spherical form, based on differences in orientation of the crystallographic axis across the substrate surface.

Processing the GaN substrate surface into a concavely spherical form diminishes, in the post-process GaN substrate surface, differences in orientation of the crystallographic axis with respect to a normal. Moreover, employing to manufacture semiconductor devices the GaN substrate in which differences in orientation of the crystallographic axis have been diminished enables uniformizing a plurality of semiconductor devices fabricated from a single GaN substrate in device characteristics, making it possible to heighten yields in manufacturing the semiconductor devices.

Furthermore, in the GaN substrate manufacturing method of the present invention, the substrate is preferably processed in the above processing step so that across the substrate surface, at other points further inward 5 mm or more from the edge face, the difference between the maximum and minimum angles formed by a line normal to the substrate surface and the crystallographic axis is brought to 0.25° or less.

Moreover, in the GaN substrate of the present invention, across the GaN substrate surface, at other points further inward 5 mm or more from the edge face, the difference between the maximum and minimum angles formed by a line normal to the substrate surface and the crystallographic axis is 0.25° or less

With the difference between a maximum and a minimum being 0.25° or less, the differences in orientation of the crystallographic axis are extremely small, which enables uniformizing in device characteristics the semiconductor devices fabricated employing one GaN substrate.

Also in the GaN substrate manufacturing method of the present invention, the substrate is preferably processed in the above processing step so that across the substrate surface, the difference between the center height and the edge-portion height along the direction normal to the center of the substrate is brought to 22 µm or less.

Furthermore, in the GaN substrate of the present invention, across the substrate surface, the difference between the center height and the edge-portion height along the direction normal to the center of the substrate is 22 µm or less.

With the difference in height in the direction of the normal to the center of the substrate between the center and the periphery being 22 µm or less, during epitaxial growth of a semiconductor layer onto the GaN substrate temperature distribution and precursor-gas distribution can be made uniform. Uniformizing such distributions enables growing uniformly the semiconductor layer on the GaN substrate, improving yield of the semiconductor devices fabricated employing the GaN substrate.

A semiconductor device in further aspect of the present invention preferably has a basal portion in which a portion of an above-described GaN substrate is employed, and a semiconductor layer is deposited onto the surface of the basal portion. Furthermore, the semiconductor device of the present invention is preferably any one of an LED, an LD, an HEMT, a Schottky diode, or an MIS transistor.

The present invention affords methods of manufacturing GaN substrates, the GaN substrates, and semiconductor devices fabricated employing the GaN substrates, in which crystal misalignment on the substrate surface is minimal.

From the following detailed description in conjunction with the accompanying drawings, the foregoing and other objects, features, aspects and advantages of the present invention will become readily apparent to those skilled in the art.

### BRIEF DESCRIPTION OF THE SEVERAL VIEWS OF THE DRAWINGS

Fig. 1 is a sectional view of a GaN substrate 1 involving Embodiment Mode 1 of the present invention.

Fig. 2 is a cross-sectional diagram representing a surface profile of the GaN substrate 1 involving Embodiment Mode 1 of the present invention.

Fig. 3 is a sectional view of a conventional GaN substrate 2 composed of single crystal.

Fig. 4 is a sectional view of a semiconductor device 110 involving Embodiment Mode 2 of the present invention.

Fig. 5 is a sectional view of a semiconductor device 120 involving Embodiment Mode 3 of the present invention.

Fig. 6 is a sectional view of a semiconductor device 130 involving Embodiment Mode 4 of the present invention.

Fig. 7 is a sectional view of a semiconductor device 140 involving Embodiment Mode 5 of the present invention.

Fig. 8 is a sectional view of a semiconductor device 150 involving Embodiment Mode 6 of the present invention.

Fig. 9 is a diagram representing a pattern (in the form of square holes) for pattering of an SiO₂ film.

Fig. 10 is a diagram representing a method of measuring a crystallographic axis.

Fig. 11 is a diagram representing a pattern (in the form of dots) of patterning of an SiO₂ film.

### DETAILED DESCRIPTION OF THE INVENTION

Hereinafter, referring to the accompanying drawings, an explanation of embodiment modes of the present invention will be made in detail. It should be understood that in describing the drawings, with the same reference marks being used for identical or equivalent features, reduplicating description will be omitted.

### Embodiment Mode 1

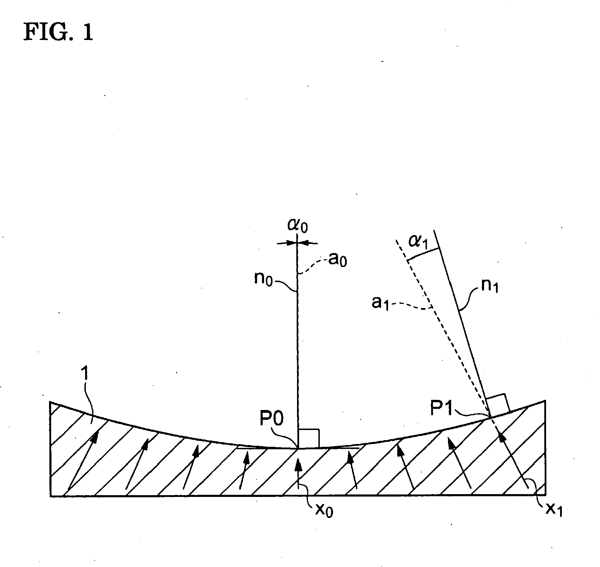

Fig. 1 is a sectional view of a GaN substrate 1 involving Embodiment Mode 1 of the present invention. The GaN substrate 1 involving the present embodiment mode is composed of GaN single crystal, and the substrate surface is processed into a concavely spherical form. The crystallographic axis of the GaN crystal in the vicinity of the center of the GaN substrate 1 is generally perpendicular to the substrate back side, but, from the center toward the edge of the GaN substrate 1, has an inclination. As just described, in the GaN substrate 1, there is a difference in crystallographic orientation between the vicinity of the center of the substrate, and the proximity of the substrate edge. This is because during GaN crystal formation onto an undersubstrate, the GaN crystal grows inclining such as to head toward the center of the undersubstrate. In contrast, in the GaN substrate 1 in Fig. 1, because the substrate surface is processed into a concavely spherical form in accordance with the crystallographic-axis inclination, the angle formed by the crystallographic axis and the normal to the substrate surface is minimized, such that differences in orientation of the crystallographic axis along the surface of the GaN substrate 1 are minimal.

The geometry of the surface of the GaN substrate 1 will be specifically explained. Letting, as illustrated in Fig. 1, the center of the GaN substrate 1 be *P0* and another point 5 mm or more inward from the edge face of the GaN substrate 1 be *P1*, letting the normal to the substrate surface at the center *P0* be *n₀* and the line along which the crystallographic axis *x₀* lies be *a₀* and letting the angle formed by the normal *n₀* to the substrate surface, through the center *P0*, and the line *a₀* be the angle α*₀*, and likewise letting the normal to the substrate surface at a *P1* be *n₁* and the line along which the crystallographic axis *x₁* lies be *a₁* and letting the angle formed by the normal *n₁* and the line *a₁* be the angle α*₁*, then the difference between the angle α*₀* and the angle α*₁* along the surface of the GaN substrate 1 is preferably 0.25° or less. The difference between the angle α*₀* and the angle α*₁* more preferably is 0.2° or less, and still more preferably is 0.1° or less, with 0° being the most preferable.

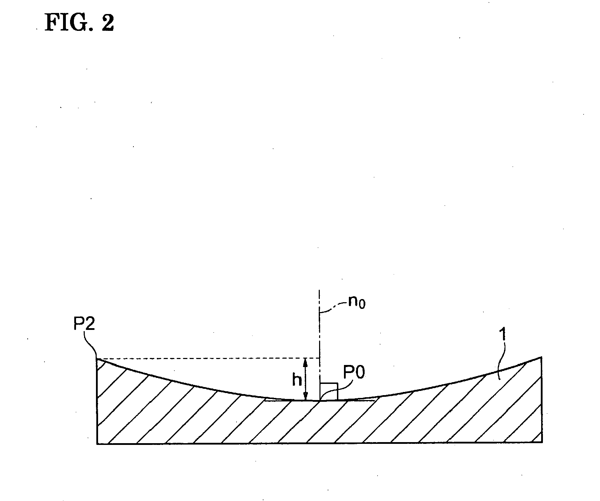

Fig. 2 is a sectional view of the geometry of the surface of a GaN substrate 1 involving Embodiment Mode 1. The center *P0* of the GaN substrate 1 in Fig. 2 is the same point as the point *P0* in Fig. 1. As illustrated in Fig. 2, the difference in height along the normal *n₀* between the edge *P2* and the center *P0* is defined as *h*. In GaN substrate 1 of the present embodiment mode, the height difference *h* is preferably 22 µm or less. If the height difference *h* is over 22 µm, when semiconductor layers are epitaxially grown onto the GaN substrate 1 in later manufacturing stages, the temperature distribution in the substrate overall might not be uniform, or the precursor gases might not pervade uniformly, and therefore, inconsistencies in the epitaxial layer composition can occur throughout the substrate. Furthermore, in carrying out photolithographic processes, there is a chance that the accuracy of the patterning will be degraded. For these reasons, the height difference *h* between the periphery *P2* and the center *P0* is preferably 22 µm or less. Moreover, with the diameter of the GaN substrate 1 being 2 inches (50.8 mm), the height difference *h* is preferably 2 µm or more, and with the diameter being 4 inches (101.6 mm), the height difference *h* is preferably 4 µm or more.

A method of manufacturing a GaN substrate involving above-described Embodiment Mode 1 is as follows.

First, GaN single crystal is grown onto an undersubstrate. As the undersubstrate, sapphire, ZnO, SiC, AlN, GaAs, LiAlO, GaAlLiO, or GaN is preferably utilized. The method of growing the GaN single crystal onto the undersubstrate is not particularly limited; metalorganic chemical vapor deposition (MOCVD), hydride vapor phase epitaxy (HVPE), or other techniques may be employed. Further techniques that may be utilized include epitaxial lateral overgrowth (ELO) in which a mask is employed; pendeo-epitaxial growth (lateral overgrowth technique in which an undersubstrate is subjected to a process whereby trenches are formed in the substrate); or void-assisted separation (VAS) in which after a GaN layer of a few µm thick is grown onto an undersubstrate, thereon a transition metal is deposited and the intermediate product is nitride-processed, and finally onto that a GaN layer is grown. GaN single crystal grown by such techniques is taken off the undersubstrate to yield substrates composed of GaN single crystal. It will be appreciated that the following manufacturing steps may be proceeded to after the GaN single crystal has been sliced with a wire saw, an internal-diameter saw, or an outer-diameter saw.

Subsequently, the surface of the substrate is processed to have a radius of curvature in accordance with differences in substrate-surface crystallographic axis orientation. The crystallographic orientation or crystallographic axis both at the center and at the edge portion of the substrate is measured with, for example, an XRD device to find the region (in most cases, the substrate center or its vicinity) having a crystallographic orientation or crystallographic axis with the highest perpendicularity to the surface, and then the difference between the crystallographic axis inclination in that region and in the edge portion of the substrate is computed, and the radius of curvature is determined based on the computation result. Alternatively, the undersubstrate may be cleaved off and cleared away from the GaN crystal in such as way as not to damage the GaN crystal, and then the crystallographic orientation or crystallographic axis can be found by measuring the GaN crystal back side-the face that was the interface between the undersubstrate and the GaN crystal-employing a contact profilometer, a non-contact profilometer, or other suitable metrological device. By these methods, the differences in orientation of the crystallographic axis with respect to the substrate surface can be gotten and the crystal-plane radius of curvature determined.

Next, the inclination of the substrate surface and of the crystallographic orientation or crystallographic axis is formulated. That is, an off axis angle is determined.

After that, based on the radius of curvature and off-axis angle, considering the heights of the center and edge in the direction of the normal to the center of the substrate-that is, the height difference *h* in Fig. 2, the substrate surface is spherically processed into concave form with a processing jig. The spherical processing method is not particularly limited; for example, employing a spherical polishing machine facilitates the processing.

In the above manner, a GaN substrate 1 involving Embodiment Mode 1 can be fabricated.

Spherically processing the substrate surface as the present embodiment mode at a radius of curvature in accordance with the differences in orientation of the crystallographic axis makes it possible to lessen variation in the angle formed by a line normal to the substrate surface and the crystallographic axis. This point will be explained, in comparison with conventional GaN substrates.

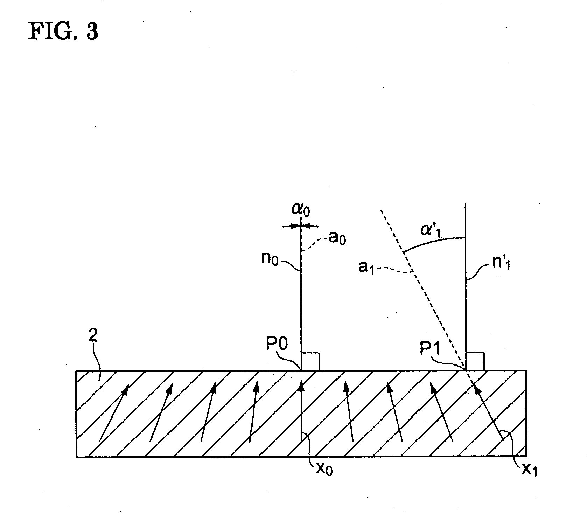

Fig. 3 is a sectional view of a conventional GaN substrate 2 composed of a single crystal. In the conventional GaN substrate 2, although inclinations of the crystallographic axis in the single crystal are the same as in the GaN substrate 1 in Fig. 1, the substrate surface is planarized. As illustrated in Fig. 3, in this GaN substrate 2, the angle α*₀* formed by the normal *no to* the substrate surface and the line which crystallographic axis lies *a₀* at *P0* is the same as in the GaN substrate 1 in Fig. 1. At point *P1*, however, while the line *a₁* of crystallographic axis *x₁* is the same as in Fig. 1, planarizing the substrate surface causes the normal *n'₁* to the substrate surface to have an angle differing from the normal *n₁* to the substrate surface in Fig. 1. Consequently, the angle α'*₁* formed by the substrate-surface normal *n'₁* and the line *a₁* at point *P1* is greater than the angle α*₁* in Embodiment Mode 1 of the present invention. Processing the substrate surface of the conventional GaN substrate 2-in which, as just described, crystal misalignment is significant-to have, in the manner of Embodiment Mode 1 of the present invention, a radius of curvature in accordance with differences in orientation of the crystallographic axis would make it possible to reduce differences in orientation of the crystallographic axis across the substrate surface, as in the Fig. 1 GaN substrate 1. Employing a GaN substrate 1, in which crystal misalignment has been minimized as just explained, in the present embodiment mode to fabricate semiconductor devices decreases nonuniformities in device properties of a plurality of semiconductor devices fabricated employing one GaN substrate, making it possible to improve yield in the semiconductor device fabrication.

In the following Embodiment Modes 2 through 6, semiconductor devices fabricated employing the GaN substrate 1 produced by Embodiment Mode 1 will be specifically explained. It should be understood that because the GaN substrate 1 is divided into a plurality of chips in a semiconductor device manufacturing process, the semiconductor devices are each provided with a basal part 1*A* that is a part of the GaN substrate 1.

### Embodiment Mode 2

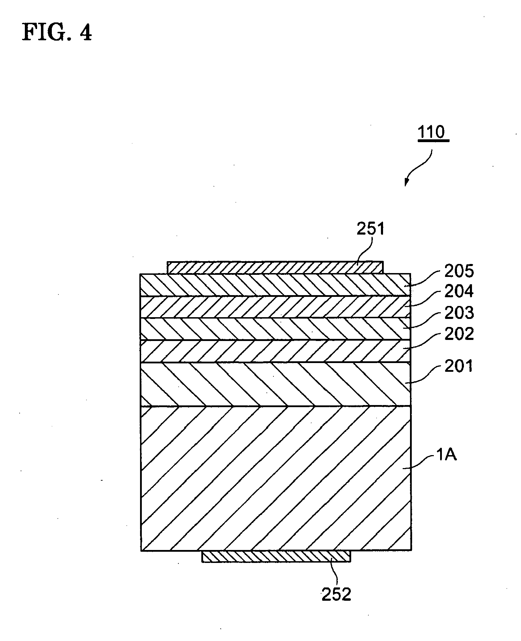

Fig. 4 is a sectional view of a semiconductor device 110 involving Embodiment Mode 2 of the present invention. As illustrated in Fig. 4, the semiconductor device 110 involving the present embodiment mode is composed of: a semiconductor layer stack in which formed successively onto the front side of a basal part 1*A* are an *n*-type GaN layer 201, an *n*-type AlGaN layer 202, an emission layer 203, a *p*-type AlGaN layer 204, and a p-type GaN layer 205; and a *p*-side electrode 251 formed onto the *p*-type GaN layer 205; and an *n*-side electrode 252 formed onto the back side of the basal part 1*A*. The semiconductor device 110 functions as a light-emitting diode (LED). It will be appreciated that the emission layer 203 may have a multiquantum well (MQW) structure in which, for example, a GaN layer and an In_{0.2}Ga_{0.8}N layer are alternately deposited.

The semiconductor device 110 in the present embodiment mode is fabricated in the following manner, for example. First, the following layers are formed successively onto the surface of a GaN substrate 1 by MOCVD: a layer serving as the *n*-type GaN layer 201; a layer serving as the *n*-type AlGaN layer 202; a layer serving as the emission layer 203; a layer serving as the *p*-type AlGaN layer 204; and a layer serving as the *p*-type GaN layer 205. Subsequently, a section that serves as the *p*-side electrode 251 is formed onto the layer serving as the *p*-type GaN layer 205. Furthermore, an electrode serving as the *n*-type electrode 252 is formed onto the back side of the basal part 1*A*, and then the structure is singulated into chips, yielding LEDs that are semiconductor devices 110.

According to Embodiment Mode 2, employing to fabricate semiconductor devices a GaN substrate 1 (cf. Fig. 1) in which differences in orientation of the crystallographic axis across the substrate surface have been reduced enables fabrication of semiconductor devices (LEDs) in which nonuniformities in device characteristics are minimal.

### Embodiment Mode 3

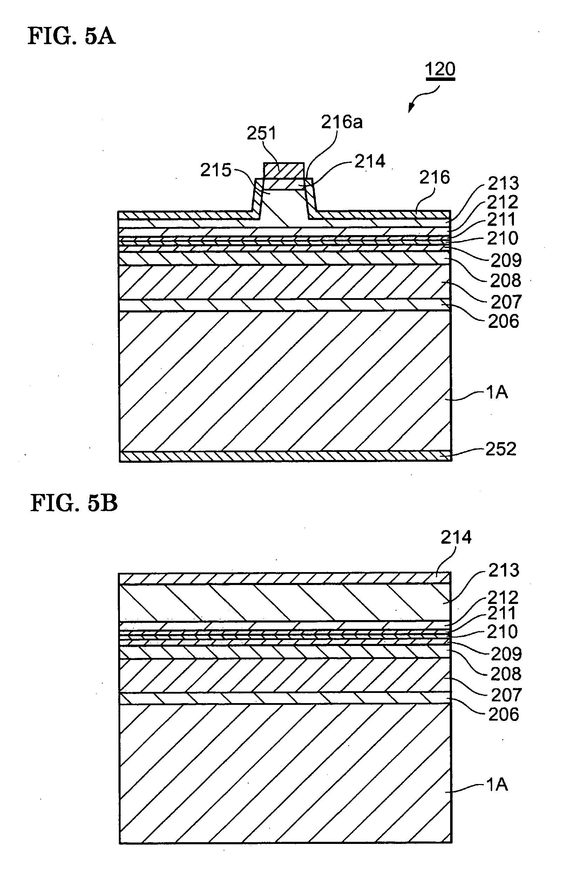

Fig. 5A is a sectional view of a semiconductor device 120 involving Embodiment Mode 3 of the present invention. As illustrated in Fig. 5A, the semiconductor device 120 involving the present embodiment mode is composed of: a basal part 1*A*; a semiconductor layer stack in which successively onto the front side of the basal part 1*A* are formed an *n*-type GaN buffer layer 206, an *n*-type AlGaN cladding layer 207, an *n*-type GaN optical waveguide layer 208, an active layer 209, an undoped InGaN deterioration-preventing layer 210, a *p*-type AlGaN gap layer 211, a *p*-type GaN optical waveguide layer 212, a *p*-type AlGaN cladding layer 213, and a *p*-type GaN contact layer 214; a *p*-side electrode 251 formed onto the top side of the *p*-type GaN contact layer 214; an *n*-side electrode 252 formed onto the back side of the basal part 1*A*; and an SiO₂ insulating film 216 covering the *p*-type AlGaN cladding layer 213. The semiconductor device 120 functions as a laser diode (LD).

The semiconductor device 120 in the present embodiment mode is fabricated in the following manner, for example. First, as illustrated in Fig. 5B, the following layers are formed successively onto the back side of a GaN substrate 1 by MOCVD: the *n*-type GaN buffer layer 206; the *n*-type AlGaN cladding layer 207; the *n*-type GaN optical waveguide layer 208; the active layer 209; the undoped InGaN deterioration-preventing layer 210; the *p*-type AlGaN gap layer 211; the *p*-type GaN optical waveguide layer 212; the *p*-type AlGaN cladding layer 213; and the *p*-type GaN contact layer 214. Next, an SiO₂ film is formed by CVD onto the entire surface of the *p*-type GaN contact layer 214, and then pattern is formed by lithography. Subsequently, as illustrated in Fig. 5A, etching is carried out to the predetermined depth of the *p*-type AlGaN cladding layer 213 in the thickness direction to form a ridge portion 215. After that, the SiO₂ film is removed, and then the SiO₂ insulating film 216 is formed onto the entire surface of the substrate. Next, an opening 216*a* is formed in the SiO₂ insulating film by resist patterning and etching, and the *p*-side electrode 251 is formed onto the surface of the *p*-type GaN contact layer 214 alone by liftoff technique. After that, the *n*-side electrode 252 is formed onto the back side of the GaN substrate 1, and then the structure is singulated into chips, yielding LDs that are semiconductor devices 120.

It should be understood that for the SiO₂ film formation, vacuum evaporation, sputtering, or other techniques may be employed, and as a method of etching the SiO₂ film, RIE in which a fluorine-containing etching gas is utilized may be also adopted.

According to Embodiment Mode 3 described above, employing to fabricate semiconductor devices a GaN substrate 1 (cf. Fig. 1) in which differences in orientation of the crystallographic axis across the substrate surface have been reduced enables fabrication of semiconductor devices (LDs) in which nonuniformities in device characteristics are minimal.

### Embodiment Mode 4

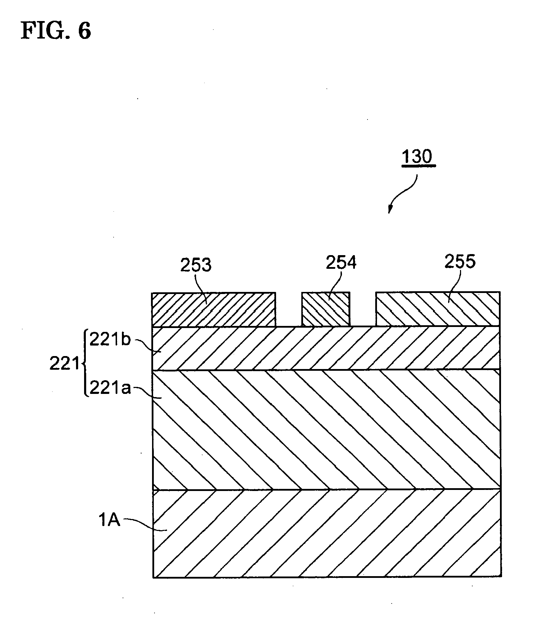

Fig. 6 is a sectional view of a semiconductor device 130 involving Embodiment Mode 4 of the present invention. As illustrated in Fig. 6, a semiconductor device 130 involving the present embodiment mode is composed of: a basal part 1*A*; a III nitride semiconductor layer 221 in which an itype GaN layer 221*a* and an *i*-type AlGaN layer 221*b* are formed successively onto the front side of the basal part 1*A*; and a source electrode 253, a gate electrode 254, and a drain electrode 255 that are formed onto the *i*-type AlGaN layer 221*b*. The semiconductor device 130 functions as a high-electron-mobility transistor (HEMT).

The semiconductor device 130 in the present embodiment mode is fabricated in the following manner, for example. Onto the surface of a GaN substrate 1, a layer serving as the *i*-type GaN layer 221*a*, and a layer serving as the *i*-type AlGaN layer 221*b* are grown. Next, the source electrode 253 and drain electrode 255 are formed onto the layer serving as the *i*-type AlGaN layer 221*b* by photolithography and liftoff techniques, and then the gate electrode 254 is additionally formed. After that, the structure is singulated into chips, yielding HEMTs that are semiconductor devices 130.

According to Embodiment Mode 4 described above, employing to fabricate semiconductor devices a GaN substrate 1 (cf. Fig. 1) in which differences in orientation of the crystallographic axis across the substrate surface have been reduced enables fabrication of semiconductor devices (HEMTs) in which nonuniformities in device characteristics are minimal. *Embodiment Mode 5*

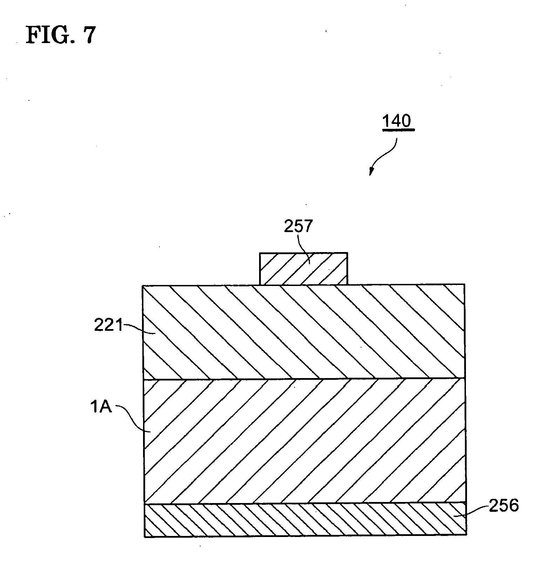

Fig. 7 is a sectional view of a semiconductor device 140 involving Embodiment Mode 5 of the present invention. As illustrated in Fig. 7, a semiconductor device 140 involving the present embodiment mode has an *n*-type GaN layer 221 as an at least single-lamina III nitride semiconductor layer on the front side of a basal part 1*A*, and is provided with an ohmic electrode 256 on the back side of the basal part 1*A*. Furthermore, the semiconductor device 140 is provided with a Schottky electrode 257 on the surface of the *n*⁻-type GaN layer 221. The semiconductor device 140 functions as a Schottky diode.

The semiconductor device 140 in the present embodiment mode is fabricated in the following manner, for example. A layer serving as the *n*⁻-type GaN layer 221 is grown onto a GaN substrate 1 by MOVCD. Next, the ohmic electrode 256 is formed onto the back side of the GaN substrate 1. Furthermore, the Schottky electrode 257 is formed onto the layer serving as the *n*⁻-type GaN layer 221 by photolithography and liftoff techniques, and then the structure is singulated into chips, yielding Schottky diodes that are semiconductor devices 140.

According to Embodiment Mode 5 described above, employing to fabricate semiconductor device the GaN substrate 1 (cf. Fig. 1) in which differences in orientation of the crystallographic axis across the substrate surface have been reduced enables fabrication of semiconductor devices (Schottky diodes) in which nonuniformities in device characteristics are minimal.

### Embodiment Mode 6

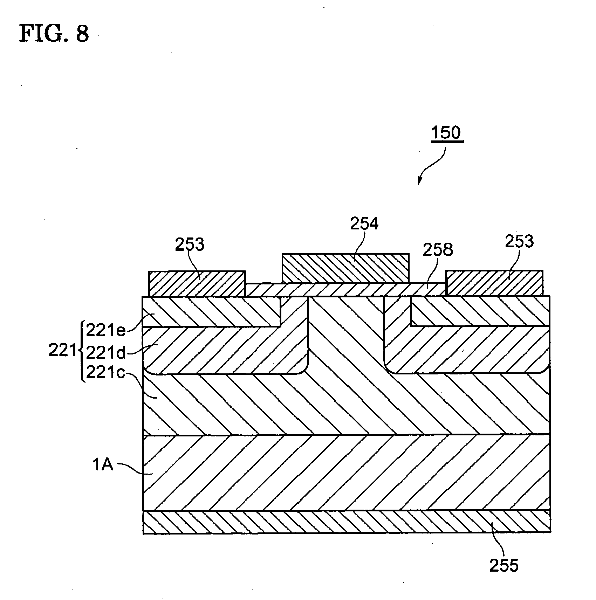

Fig. 8 is a sectional view of a semiconductor device 150 involving Embodiment Mode 6 of the present invention. As illustrated in Fig. 8, the semiconductor device 150 involving the present embodiment mode has a basal part 1*A*, and a III nitride semiconductor layer 221 composed of: an *n*⁻-type GaN layer 221c formed onto the front side of the basal part 1*A*; a *p*-type GaN layer 22 1*d* formed so as to be embedded in two locations on the right and left of the *n*⁻-type GaN layer 221*c*; and an *n*⁺-type GaN layer 221*e*. Furthermore, the semiconductor device 150 is provided with: a drain electrode 255 formed onto the back side of the basal part 1A; a gate electrode 254 formed onto the *n*⁻-type GaN layer 221c with an insulating film 258 intervening between the *n*⁻-type GaN layer 221c and the gate electrode 254; and source electrodes 253 formed onto the *n*⁺-type GaN layer 221*e* in the two locations. The semiconductor device 150 functions as a metal-insulator semiconductor (MIS) transistor.

The semiconductor device 150 in the present embodiment mode is fabricated in the following manner, for example. A layer serving as the *n*⁻-type GaN layer 221*c* is formed onto a GaN substrate 1 by MOCVD. Subsequently, by selective ion implantation the *p*-type GaN layer 221*d* and *n*⁺-type GaN layer 221*e* are formed successively onto partial regions of the surface of the layer serving as the *n*⁻-type GaN layer. Next, the surface of a portion serving as the *n*⁻-type GaN layer 221*c* is protected with an SiO₂ film, and then annealing is carried out to activate the implanted ions. As an MIS insulating film, an SiO₂ film is formed by plasma enhanced chemical vapor deposition (P-CVD), and then by photolithography and selective etching employing a buffered hydrofluoric acid a portion of the MIS insulating film is etched, and by a liftoff technique the source electrode 253 is formed on the top side of a layer serving as the *n*⁺-type GaN layer 221*e*. Next, the gate electrode 254 is formed onto the above insulating film 256 for MIS by photolithography and liftoff techniques. Furthermore, the drain electrode 255 is formed onto the entire back side of the GaN substrate 1, and then the structure is singulated into chips, yielding MIS transistors that are semiconductor devices 150.

According to Embodiment Mode 6 described above, employing to fabricate semiconductor devices a GaN substrate in which differences in orientation of the crystallographic axis on the substrate surface have been reduced enables fabrication of semiconductor devices (MIS transistors) in which nonuniformities in device characteristics are minimal.

### Embodiments

The present invention will be described more specifically below, with semiconductor devices fabricated employing GaN substrates manufactured based on the manufacturing method involving the present invention as embodiments, and with semiconductor devices fabricated employing conventional GaN substrates as comparative examples, but the present invention is not limited the following embodiments.

### Embodiments 1 through 4 and Comparative Example 1

### Substrate fabrication and radius of curvature computation

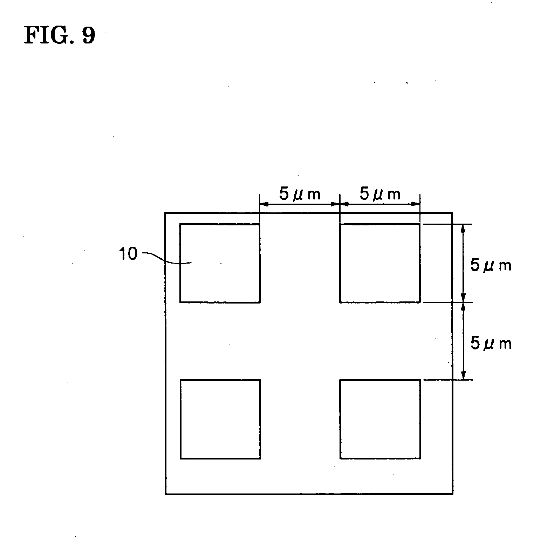

A SiO₂ film was formed onto 51 mm-diameter (111) plane GaAs substrates so as to be 100 nm in thickness. Next, the SiO₂ film was subjected to patterning by photolithography so as to have a mask pattern in the form of square holes (openings 10 were squares 5 µm on a side, and intervals between the openings were 5 µm) as illustrated in Fig. 9. After that, the GaAs substrates were inserted into a HVPE reactor to grow GaN layers under the conditions shown in Table I. After the GaAs substrates were removed from the GaN crystals obtained from the growth, the GaN crystals were sliced parallel to a plane in the vicinity of the center of the back side of the GaN crystals, and then the outer periphery of the crystals was processed to produce 400 µm-thick, 50.8 mm (2 inch)-diameter GaN single crystal substrates.

In the above obtained single crystals, orientation of the principal faces and misalignment of crystallographic axes (plane orientations) were measured with a powder XRD apparatus. The crystallographic axis measuring method obeyed a post-substrate-surface-processing metrology to be described later. As shown in Table I, in all of the Embodiments 1 through 4 and Comparative Example 1, the principal-face orientations were the (0001) plane.

### Substrate surface processing

As shown in Table I, the substrate surfaces were processed so as have a spherical contour, by employing processing jigs with radius of curvature of 10 m, 50 m, 20 m, and 15 m respectively in Embodiments 1 through 4. In Comparative Example 1, the substrate surface was processed so as to be planar, by employing a processing jig with radius of curvature of 100,000,000 m. *Measurement ofsubstrate after processing*

Crystal misalignments on the GaN crystal surfaces that had been already processed were measured with the two-crystal XRD apparatus.

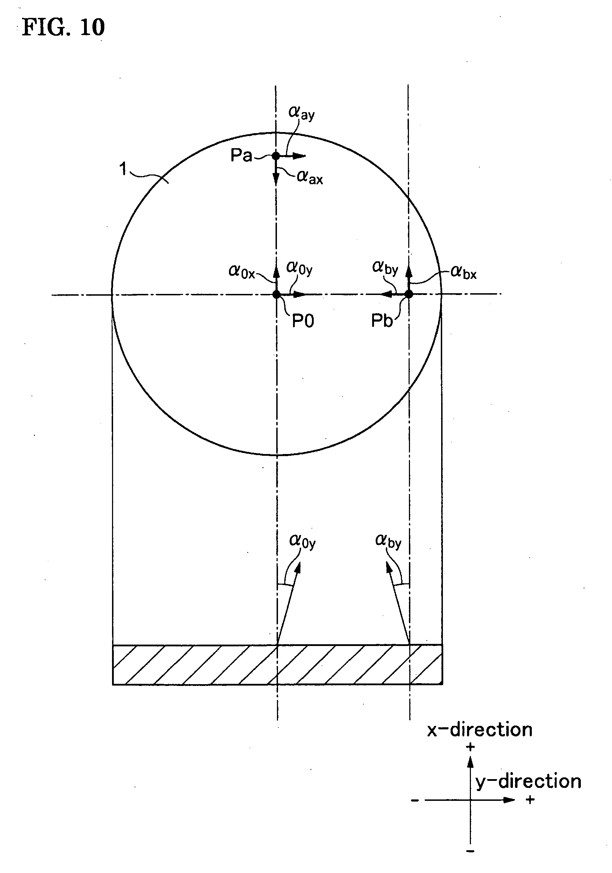

The measuring method is as follows. Fig. 10 is a diagram representing a method of measuring crystallographic axes. As illustrated in Fig. 10, orientations of crystallographic axis were measured at the following three points: the center *P0* of the surface of the single crystal; point *Pa* in a position 5 mm from the outer periphery of the single crystal; and point *Pb*, also a position 5 mm away from the outer periphery of the single crystal, on a line orthogonal to a line connecting point *Pa* and point *P0*. In the crystallographic orientations, two components in the direction (*x*-direction) connecting points *P0* and *Pa,* and in the direction (*y*-direction) orthogonal to the *x*-direction, connecting *P0* and *Pb* were measured. As to these two components, for example, among crystallographic axis inclinations at the center *P0*, an inclination in the *x*-direction was defined as α_{*0*x}*,* with an inclination in the *y*-direction being defined as α*_{0y}*. In the same manner, crystallographic axis inclinations at *Pa* were defined respectively as α*ₐₓ* and α*_{ay}*. And, crystallographic axis inclinations at *Pb* were defined respectively as α*_{bx}* and α*_{by}*. Furthermore, as to angles, with the direction of a normal to the substrate surface being defined as 0°, in the *x*-direction, a crystallographic axis inclination in the direction from *P0* toward *Pa* was defined as positive, and an inclination in the opposite direction was defined as negative. Also in the *y*-direction, as in the *x*-direction, a crystallographic axis inclination in the direction from *P0* toward *Pb* was defined as positive, and an inclination in the opposite direction was defined as negative. Based on the obtained results, between *P0* and *Pa*, the difference in inclination in the *x*-direction (|α_{0*x*}|-|α*ₐₓ*|), and the difference in inclination in the *y*-direction (|α_{0*y*}|-|α*_{ay}*|) were determined. Also between *P0* and *Pb*, as between *P0* and *Pa*, the difference in inclination in the *x*-direction (|α_{0*x*}|-|α*_{bx}*|) and the difference in inclination in the *y*-direction (|α_{0*y*}|-|α*_{by}*|) were determined.

Next, a difference in height between the center *P0* and the edge in the direction of the normal to the center *P0* was determined. Specifically, at a total of two points-the center *P0* of the substrate surface and any one point on the edge, substrate thicknesses were measured, and the difference between the substrate thicknesses was defined as the height difference.

### Semiconductor device fabrication and yield evaluation

The GaN substrates in Embodiments 1 through 4 and Comparative Example 1 were employed to fabricate LEDs that were semiconductor devices 110 involving Embodiment Mode 1 of the present invention. The specific fabrication method is as follows.

As an at least single-lamina III nitride semiconductor layer, a 5 µm-thick *n*-type GaN layer, a 3 nm-thick In_{0.2}Ga_{0.8}N layer, a 60 nm thick-Al_{0.2}Ga_{0.8}N layer, and a 150 nm-thick *p*-type GaN layer were epitaxially grown successively onto each of the GaN substrates of Embodiments 1 through 4 and Comparative Example 1 by MOCVD.

Furthermore, a 100 nm-thick *p*-side electrode was formed onto the surface of the *p*-type GaN layer. Next, in order to facilitate division into chips, the surface of the *p*-type GaN layer was attached to a holder for polishing, and then with slurry containing SiC abrasives of 30 µm average particle diameter, polishing was carried out until a thickness of the GaN substrates was brought from 400 µm to 100 µm.

Subsequently, an *n*-side electrode of 80 µm in diameter × 100 nm in thickness was formed at a position that would come to the central part of the back side of the GaN substrates when they were singulated into chips, and then dicing into chips of 400 µm × 400µm was carried out. In the above manner, LEDs involving Embodiments 1 through 4 and Comparative Example 1 were fabricated.

Yields in the fabricated LEDs in the foregoing were evaluated in the following manner. First, among the LEDs fabricated in the above manner, emission intensities of devices in a position within a radius of 2.5 mm (central region) from the center of the GaN substrates that had not already divided were measured to calculate average *Av* and standard deviation o. Subsequently, emission intensities of all the devices fabricated from the GaN substrates were measured, and those whose results were at or above <*Av* - *o*> of the difference between the average of, and the standard deviation of, the emission intensities of the devices in the central region were taken to be qualifying, to determine percentage of the qualifying devices (%) (= the number of qualifying devices / the total number of devices × 100).

The above results are set forth in Table I. In the semiconductor devices (LEDs) fabricated employing the substrates of Embodiments 1 through 4, high yield could be obtained, compared with fabricating semiconductor devices employing the substrate of Comparative Example 1. Furthermore, lessening the difference in height between the center of, and the edge of, the substrate surface led to higher yield.

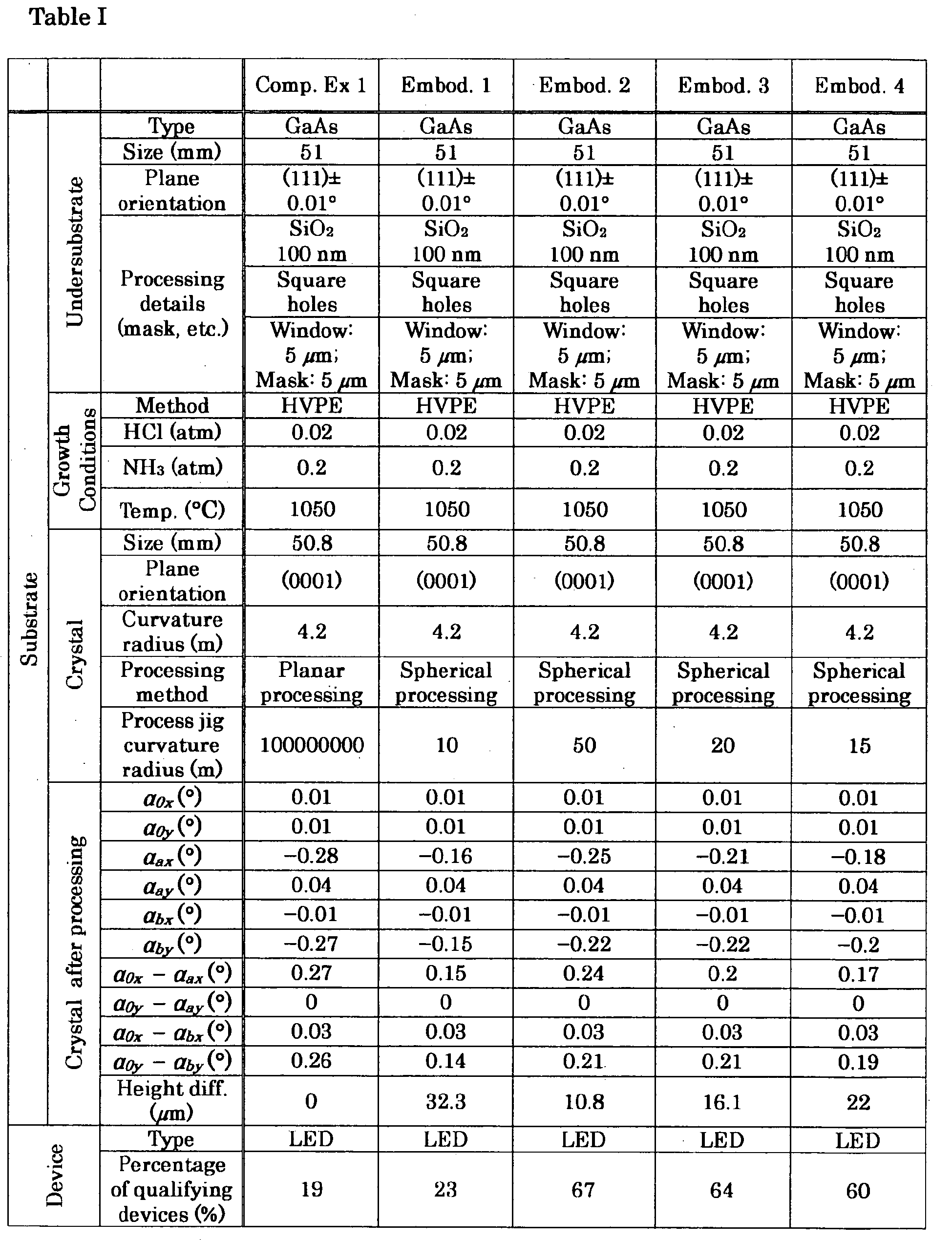

### 2. Embodiments 5 and 6

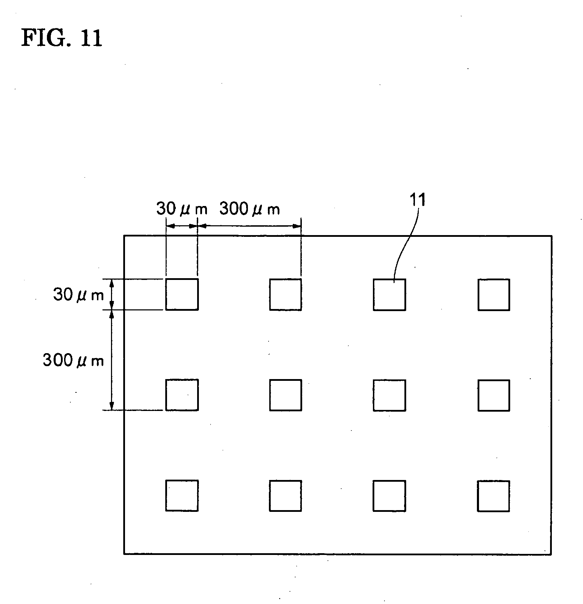

Embodiments 5 and 6 are the same as Embodiments 1 through 4, apart from form of a mask of SiO₂ film in GaN single crystal formation. That is, first, an SiO₂ film was formed onto GaAs substrates so as to be 100 nm in thickness. Next, the SiO₂ film was subjected to pattern formation by photolithography so as to be in the form of dots of mask pattern (mask portions 11 were squares 30 µm on a side, and the mask portion pitch was 300 µm) as illustrated in Fig. 11. After that, the GaAs substrates were inserted into a HVPE reactor to grow GaN crystals. As a result of pattering the SiO₂ film in this manner, the GaN crystals having a structure in which closed defect regions were arranged in the form of dots in a low crystal defect region were formed.

The surfaces of substrates produced from the GaN crystals were spherically processed by the substrate surface processing method described above to obtain GaN substrates employed in Embodiments 5 and 6. In the GaN substrates, inclinations of crystallographic axes on the surfaces and differences in height between the center and the edge of the surfaces were measured. Moreover, the GaN substrates were employed to fabricate semiconductor devices (LEDs) involving Embodiments 5 and 6 by the semiconductor device manufacturing method described above, and yields were evaluated.

### 3. Embodiments 7 and 8

Embodiments 7 and 8 are the same as Embodiments 5 and 6, apart from form of a mask of SiO₂ film in GaN single crystal formation. That is, in Embodiments 7 and 8, an SiO₂ film was subjected to pattern formation so as to be in the form of stripes with mask portion width of 30 µm, and with pitch of 300 µm. As a result of such pattern formation, GaN crystals having a structure in which low crystal defect regions and high crystal defect regions were arranged alternately in the form of stripes were formed.

The surfaces of substrates produced from the GaN crystals were spherically processed by the substrate surface processing method described above to obtain GaN substrates employed in Embodiments 7 and 8. In the GaN substrates, inclinations of crystallographic axes on the surfaces and differences in height between the center of, and the edge of, the surfaces were measured. Moreover, the GaN substrates were employed to fabricate semiconductor devices (LEDs) involving Embodiments 7 and 8 by the semiconductor device manufacturing method described above, and yields were evaluated.

The conditions for processing the substrates of Embodiments 5 through 8 and the evaluation results are set forth in Table II. Also in the semiconductor devices (LEDs) fabricated employing the substrates of Embodiments 5 through 8, high yields could be obtained.

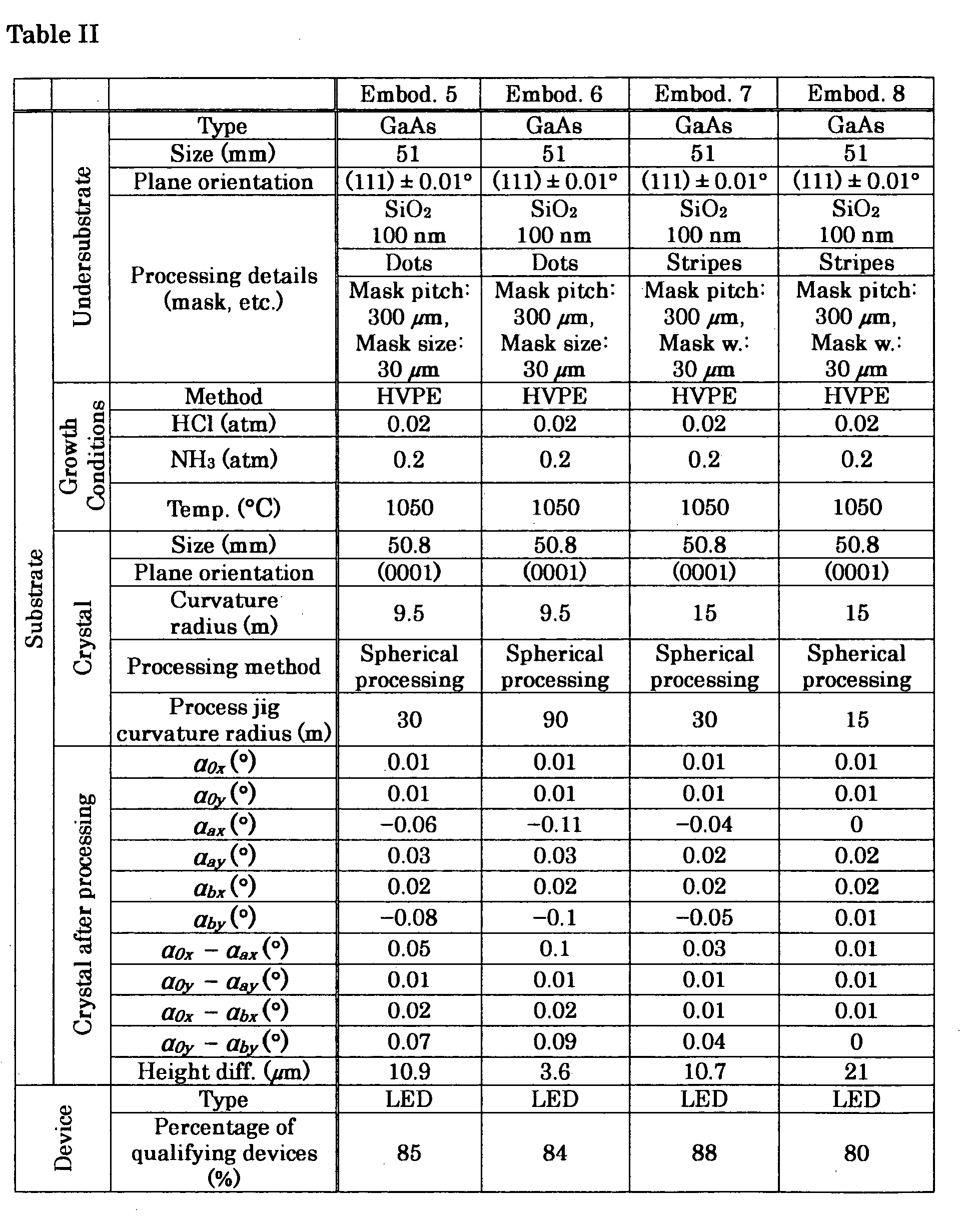

### 4. Embodiment 9

In Embodiment 9, a GaN layer was grown by 500 nm onto a 51 mm-diameter (0001) plane sapphire substrate by MOCVD. Next, a titanium layer was evaporated by 2 µm onto the GaN layer, and heat treatment was carried out. After the heat treatment, the substrate was inserted into an HVPE reactor to grown a GaN layer under the conditions shown in Table III to obtain the GaN crystal.

The surface of a substrate produced from the GaN crystal was spherically processed by the substrate surface processing method described above to produce a GaN substrate employed in Embodiment 9. In the GaN substrate, inclinations of crystallographic axes on the substrate surface and a difference in height between the center of, and the edge of, the surface were measured. Moreover, the GaN substrate was employed to fabricate semiconductor devices (LEDs) by the semiconductor device manufacturing method described above, and yield was evaluated.

### 5. Embodiment 10

In Embodiment 10, a GaN crystal formed by the method in Embodiment 2 was utilized as an undersubstrate. The 2 inch-diameter GaN crystal was inserted into an HVPE reactor, and GaN was grown onto the (0001) plane of the GaN crystal serving as the undersubstrate under the conditions shown in Table I, to form a GaN crystal.

The surface of a substrate produced from the GaN crystal was spherically processed by the substrate surface processing method described above to obtain a GaN substrate in Embodiment 10. In the GaN substrate, crystallographic orientations on the substrate surface and a difference in height between the center of, and the edge of the substrate were measured. Moreover, the GaN substrate was employed to fabricate semiconductor devices (LEDs) by the semiconductor device manufacturing method described above, and yield was evaluated.

Conditions for processing the substrates of Embodiments 9 and 10 and evaluation results are set forth in Table III. In the semiconductor devices (LEDs) fabricated employing the substrates of Embodiments 9 and 10, high yields could be obtained.

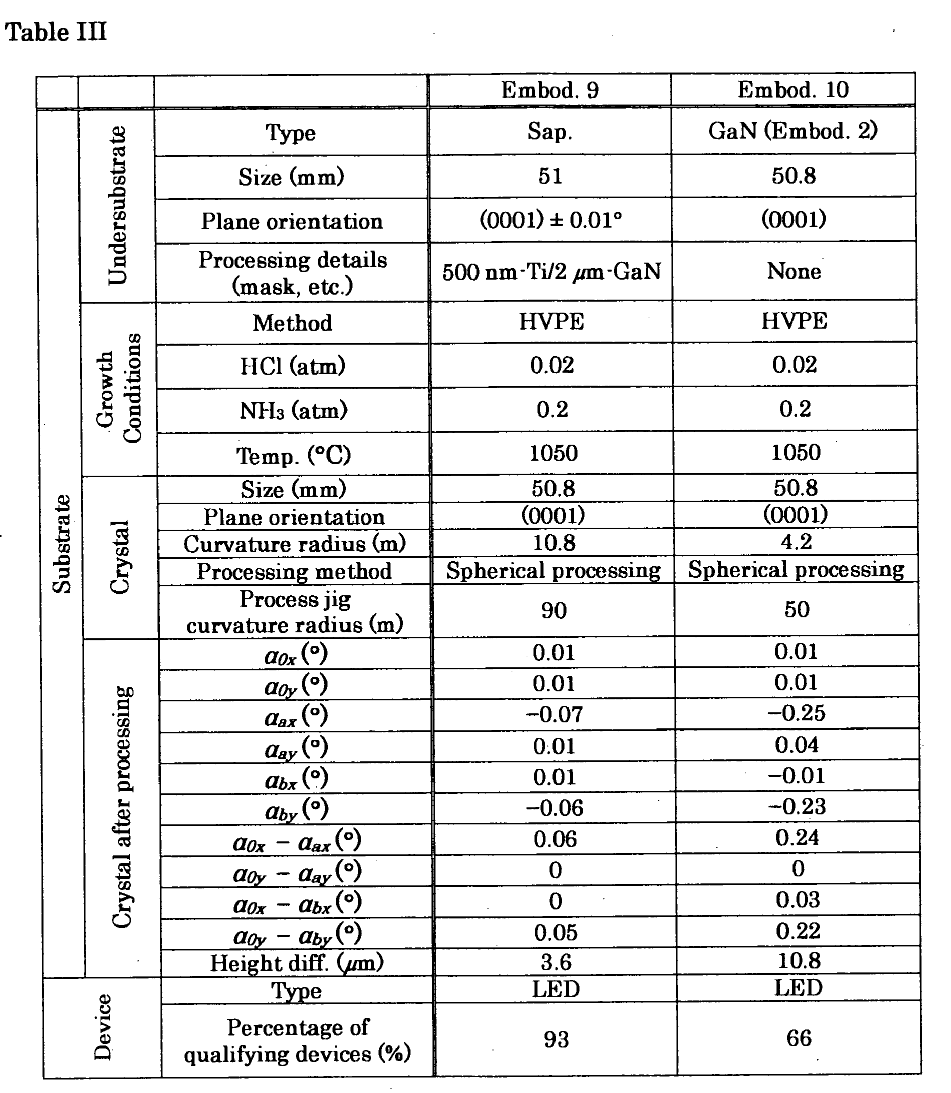

### 6. Embodiments 11 through 13

As Embodiments 11 through 13, GaAs substrates in which an inclination was made in the <1-10> directions respectively at 10°, 20°, and 30° with respect to the (111) plane were employed to grow GaN crystals having an off-axis angle. Conditions during the growth were the same as in Embodiments 5 and 6, and the GaN crystals were grown after formation of a mask pattern in the form of dots.

The surfaces of substrates produced from the GaN crystals were spherically processed by the substrate surface processing method described above to obtain GaN substrates. The GaN substrates were arranged in a XRD meter so that the <1-10> directions were in the *x*-direction in Fig. 9 to measure crystallographic orientations on the substrate surfaces. Furthermore, differences in height between the center of, and the edge of, the substrate surfaces were measured. Moreover, the GaN substrates were employed to fabricate semiconductor devices (LEDs) by the semiconductor device manufacturing method described above, and yields were evaluated.

Conditions for processing the substrates of Embodiments 11 through 13 and the evaluation results are set forth in Table IV In the semiconductor devices (LEDs) fabricated employing the GaN substrates having an off-axis angle as in Embodiments 11 through 13, high yields could be obtained.

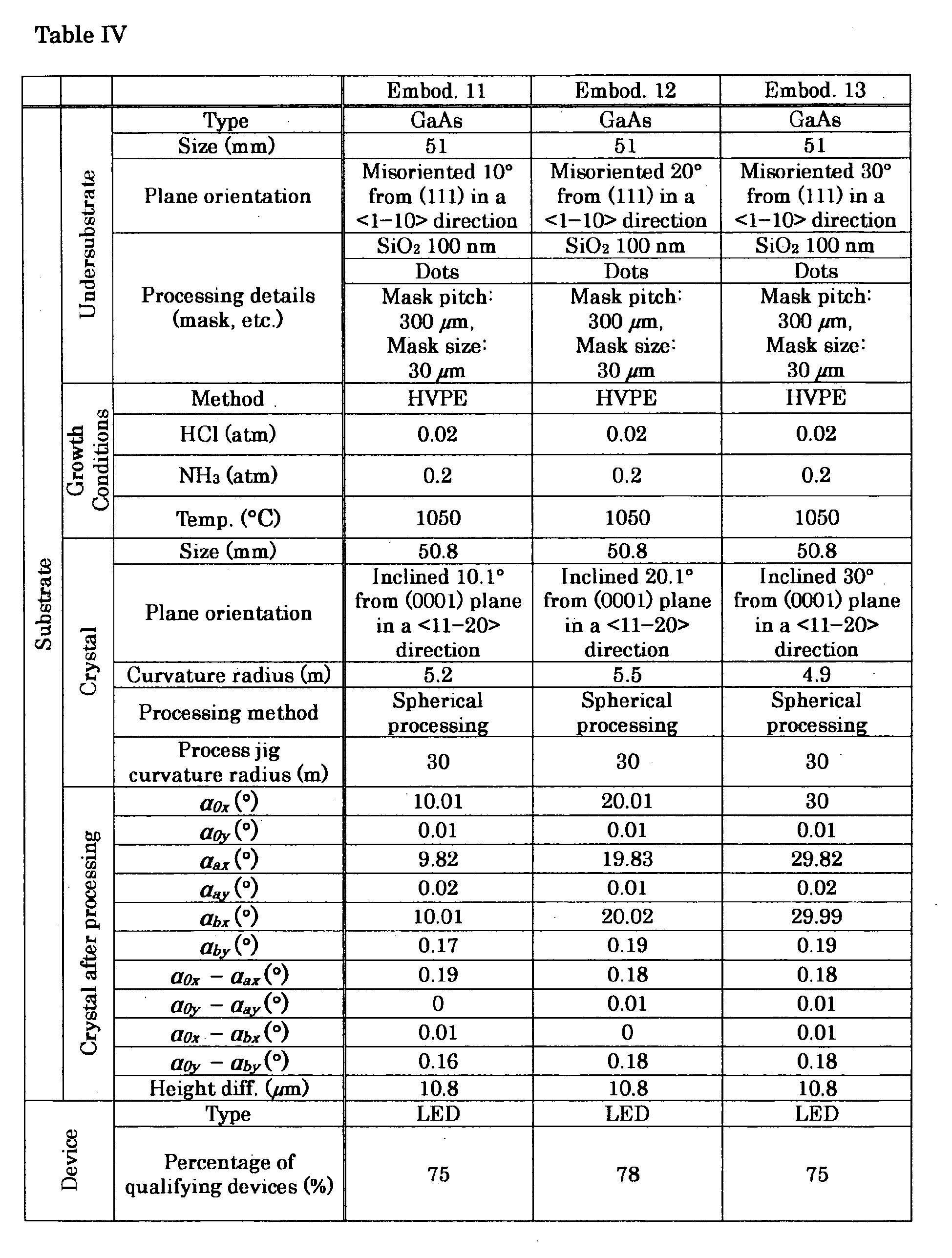

### 7. Embodiments 14 through 17

As Embodiments 14 through 17, GaN substrates having on the principal face a non-polar plane orientation perpendicular to the (0001) plane were fabricated. As shown in Table V, in Embodiment 14, a GaN crystal was formed in the same manner as in Embodiment 9, apart from forming GaN onto the (11-20) *A*-plane of a sapphire substrate. Furthermore, GaN crystals were formed in the same manner as in Embodiments 7 and 8, employing the (100) plain of a LiAlO₂ substrate in Embodiment 15, and employing the (100) plane of a LiGaAlO₄ substrate in Embodiment 16, as an undersubstrate. Plane orientations of the GaN crystals formed in the manner of Embodiments 14 through 16 were confirmed to be (1-100) *M* plane.

In Embodiment 17, a GaN crystal was formed in the same manner as in Embodiment 9, apart from forming GaN onto the (1-102) *R*-plane of a sapphire substrate. Plane orientation of the GaN crystal was confirmed to be the (11-20) *A*-plane.

The surfaces of substrates produced from the GaN crystals were spherically processed by the substrate surface processing method described above to fabricate GaN substrates, and then inclinations of crystallographic axes on the GaN substrate surfaces and differences in eight between the center of, and the edge of, the surfaces were measured. Moreover, the GaN substrates were employed to fabricate semiconductor devices (LEDs) by the semiconductor device manufacturing method described above, and yields were evaluated.

Conditions for processing the substrates of Embodiment 14 through 17 and evaluation results are set forth in Table V In the semiconductor devices (LEDs) fabricated employing the GaN substrates having the non-polar plane on the principal face as in Embodiments 14 through 17, high yields could be obtained.

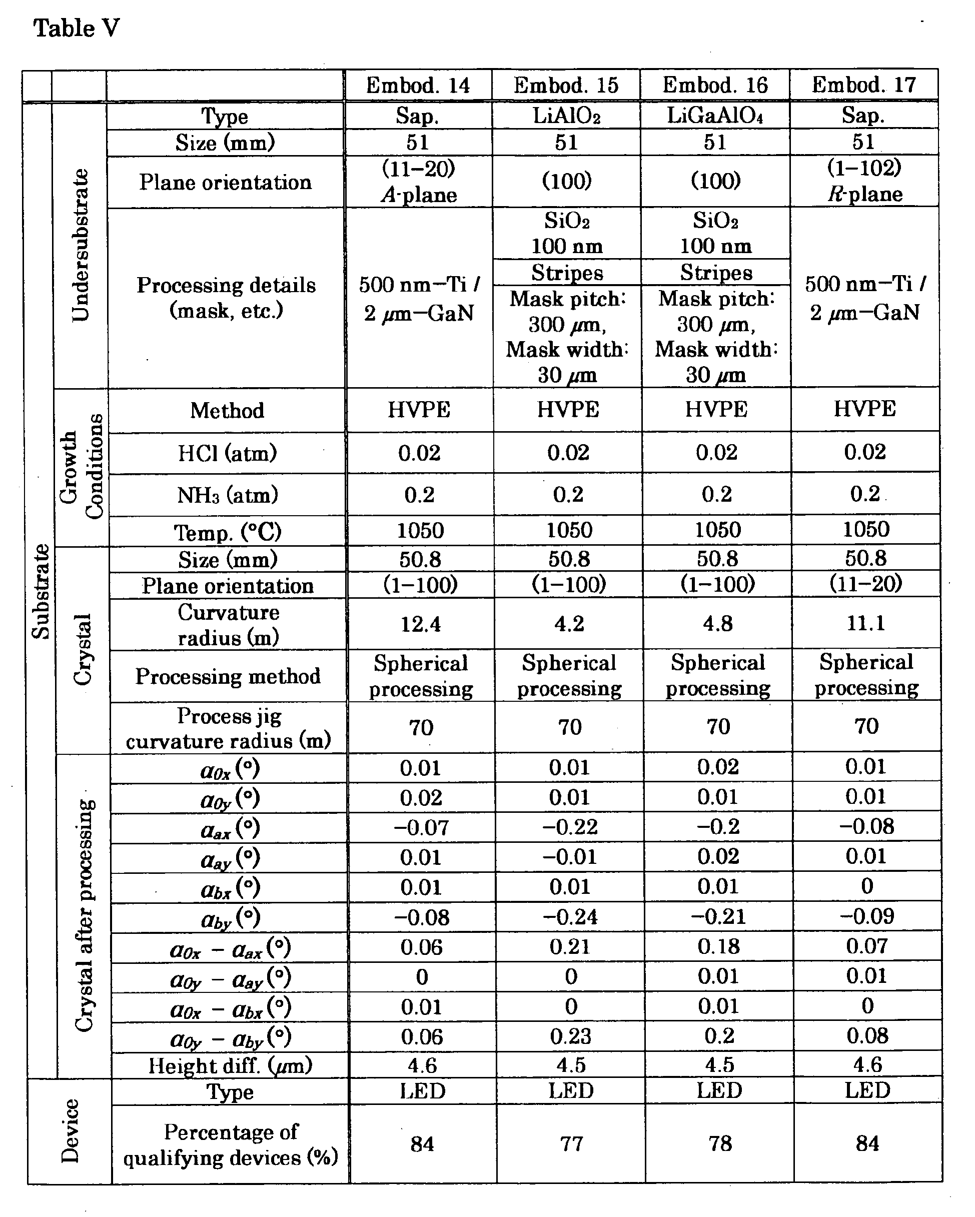

### 8. Embodiments 18 through 20

As Embodiments 18 through 20, in the situation in which substrates of large size were employed, evaluation was carried out. As shown in Table VI, as Embodiment 18, GaN was grown onto the (111) plane of a 102 mm-diameter GaAs substrate. Furthermore, as Embodiment 19, GaN was grown onto the (111) plane of a 155 mm-diameter GaAs substrate. Moreover, as Embodiment 20, GaN was grown onto the (0001) plane of a 102 mm-diameter sapphire substrate. In the GaN growth, in Embodiments 18 and 19, a pattern of an SiO₂ film in the form of dots was formed, and then a GaN layer was grown, as in Embodiments 5 and 6. On the other hand, in Embodiment 20, a GaN layer was grown in the same manner as in Embodiment 9.

The surfaces of substrates produced from the GaN crystals were spherically processed by the substrate surface processing method described above to produced GaN substrates, and then inclinations of crystal axes on the GaN substrate surfaces and differences in height between the center of, and the edge of, the surfaces were measured. Furthermore, the GaN substrates were employed to fabricate semiconductor devices (LEDs) by the semiconductor device manufacturing method described above, and yields were evaluated.

Conditions for processing the substrates of Embodiments 18 through 20 and evaluation results are set forth in Table VI. In the semiconductor devices (LEDs) fabricated employing the large GaN substrates as Embodiments 18 through 20, high yields could be obtained.

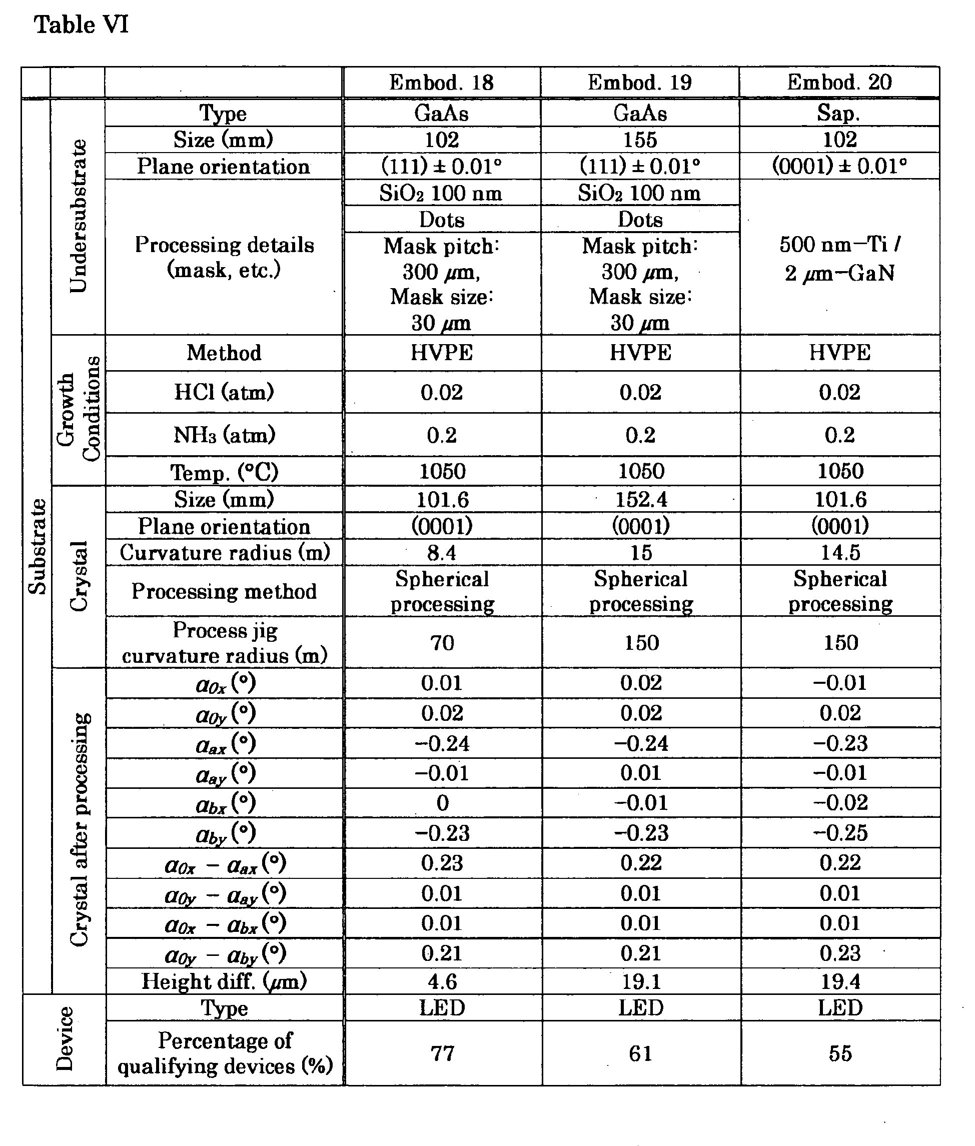

### 9. Embodiments 21 through 28

### GaN substrate fabrication

In GaN substrates employed in Embodiments 22, 24, 26 and 28, as in Embodiment 6, onto the (111) plane of a GaAs substrate, a pattern of an SiO₂ film in the form of dots was formed, and then a GaN layer was grown, to fabricate substrates composed of GaN crystal. The surfaces of the substrates were spherically processed by the substrate surface processing method described above with a processing jig having radius of curvature of 90 m to fabricate the GaN substrates employed in Embodiments 22, 24, 26 and 28, and inclinations of crystallographic axes on the substrate surfaces and differences in height between the center of, and the edge of, the surfaces were measured.

In GaN substrates employed in Embodiments 21, 23, 25 and 27, as in Embodiment 6, onto the (111) plane of a GaAs substrate, a pattern of an SiO₂ film in the form of dots was formed, and then a GaN layer was grown, to fabricate substrates composed of GaN crystal. The surfaces of the substrates were spherically processed as in Embodiment 1 with a processing jig having radius of curvature of 10 m to fabricate the GaN substrates employed in Embodiments 21, 23, 25 and 27, and inclinations of crystallographic axes on the substrate surfaces and differences in height between the center of, and the edge of, the surfaces were measured.

### Embodiments 21 and 22

The GaN substrates fabricated in the above manner were employed to fabricate, as Embodiments 21 and 22, LDs that were semiconductor devices 120 involving Embodiment Mode 3 of the present invention. The specific manufacturing method is as follows.

As a III nitride semiconductor layer, the following layers were epitaxially grown successively onto the surfaces of the 400 µm-thick GaN substrates by MOCVD:
a 0.05 µm-thick *n*-type GaN buffer layer doped with Si;
a 1.0 µm-thick *n*-type Al_{0.08}Ga_{0.92}N cladding layer doped with Si;
an active layer having a multiquantum well structure in which a 0.1 µm-thick *n*-type GaN optical waveguide layer doped with Si, an undoped 3 nm-thick In_{0.15}Ga_{0.85}N layer, and a 6 nm-thick In_{0.03}Ga_{0.97}N layer were repeated 5 times;
an undoped 0.01 µm-thick Al_{0.2}Ga_{0.8}N deterioration-preventing layer;
a 10 nm-thick *p*-type Al_{0.2}Ga_{0.8}N gap layer doped with magnesium (Mg);
a 0.1 µm-thick *p*-type GaN optical waveguide layer doped with Mg;
a 0.3 µm-thick *p*-type Al_{0.08}Ga_{0.92}N cladding layer doped with Mg; and
a *p*-type GaN contact layer doped with Mg. After the epitaxial growth, the GaN substrates were taken out from a MOCVD reactor. Subsequently, a 0.1 µm-thick SiO₂ film was formed onto the entire surface of the *p*-type GaN contact layer by CVD, and then a pattern corresponding to form of a ridge portion was formed onto the SiO₂ film by lithography.

Next, with the SiO₂ film as mask, etching was carried out to the predetermined depth in the *p*-type AlGaN cladding layer in the thickness direction by RIE to form a ridge present extending in the <1-100> directions. The ridge was 2 µm in width. As an etching gas in RIE, a chlorine-based gas was utilized.

Next, the SiO₂ film employed as etching mask was removed by etching, and then a 0.3 µm-thick SiO₂ insulating film was deposited onto the entire surface of the substrates by CVD. Subsequently, a resist pattern covering the surface of the insulating film in a region outside a region in which a *p*-side electrode would be formed was formed by lithography The insulating film was etched with the resist pattern as a mask to form openings.

Next, with the resist pattern being remained, the *p*-side electrode was formed onto the entire substrate surfaces by vacuum evaporation technique, and then the resist pattern was removed together with the *p*-side electrode formed onto the resist pattern to form the *p*-side electrode only onto the *p*-type GaN contact layer. In order to facilitate division into chips, the surface of the *p*-type GaN layer was attached to a holder for polishing, and then with slurry containing SiC abrasives of 30 µm abrasive particle diameter, polishing was carried out until thickness of the substrates decreased from 400 µm to 100 µm.

Next, an *n*-side electrode was formed onto the back side of the GaN substrates. After that, along the contour of a device region, scribing of the GaN substrates on which a laser structure was formed in the above manner was carried out by cleavage to process the substrates into the form of a bar, and a pair of resonator end sections were formed. Subsequently, the resonator end sections were coated, and then scribing of the laser bar was carried out again by, for example, cleavage to make the laser bar into chips.

LDs involving Embodiments 21 and 22 were fabricated in the above manner to evaluate yields. Although the yield evaluating method was the same as in the LEDs described above, laser lifetime was adopted as device characteristics of the LDs. The results are set forth in table VII. Also in the implementation in which the LDs were fabricated as semiconductor devices, spherically processing the surfaces of the GaN substrates led to high yields. Furthermore, decreasing difference in height between the center of, and the edge of, the substrate surfaces made it possible to obtain higher yields. Herein, semiconductor device yield in the situation in which the surface of the GaN substrate of Embodiment 21 was employed without spherically processing the surface was some 18 %, which was low by comparison with spherically processing the surface.

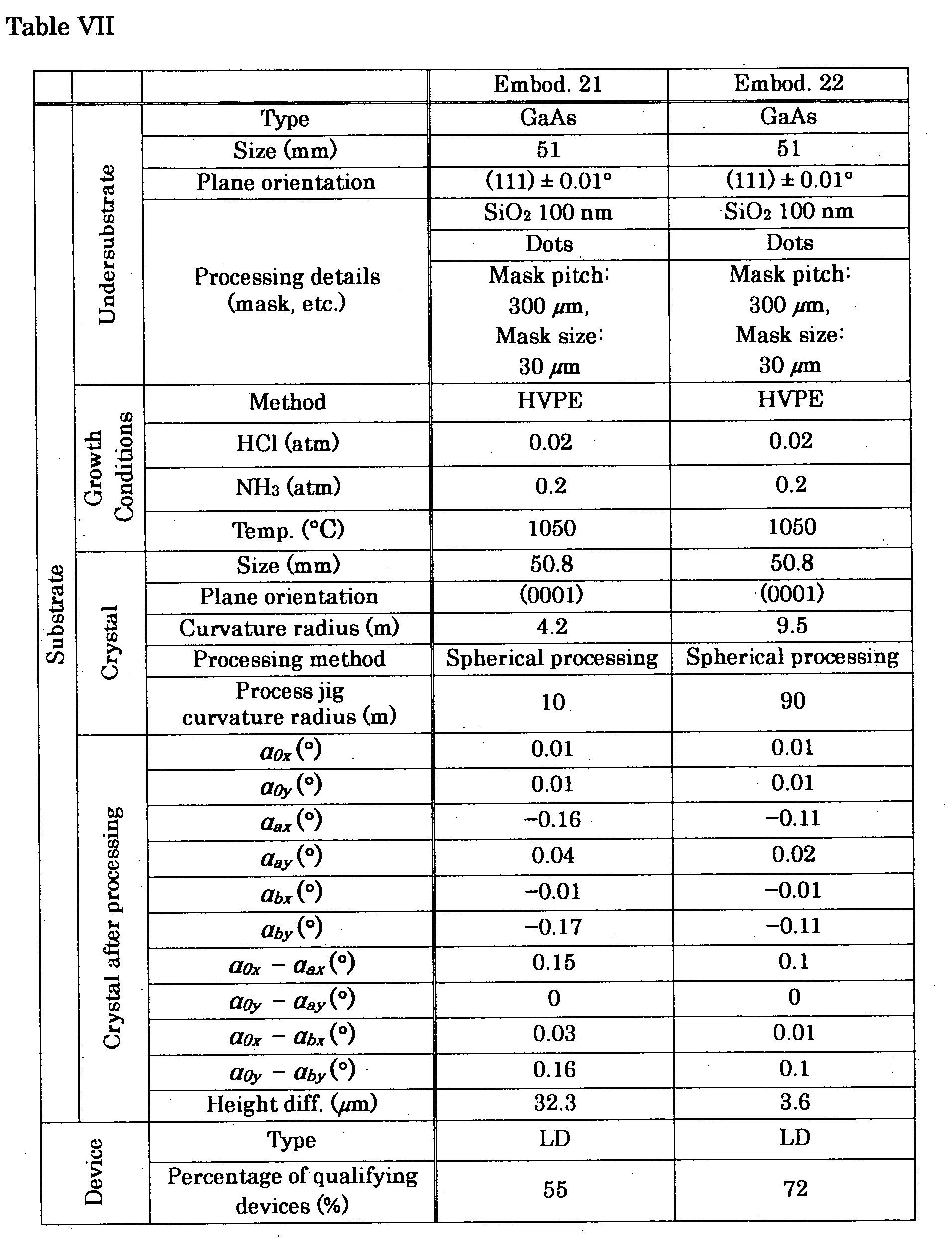

### Embodiments 23 and 24

The GaN substrates fabricated in the manner described above were employed to fabricate, as Embodiments 23 and 24, HEMTs that were semiconductor devices 130 involving Embodiment Mode 4 of the present invention. The specific manufacturing method is as follows.

As a III nitride semiconductor layer, a 3 µm-thick *i*-type GaN layer, and a 30 nm-thick *i*-type Al_{0.15}Ga_{0.85}N layer were grown onto the surfaces of the 400 µm-thick GaN substrates by MOCVD.

Next, by photolithography and liftoff techniques, as a source and drain electrodes, onto the *i*-type Al_{0.15}Ga_{0.85}N layer, a composite layer with a Ti layer (50 nm in thickness)/Al layer (100 nm in thickness)/Ti layer (20 nm in thickness)/Au layer (200 nm in thickness) was formed by heating at 800°C for 30 seconds, and alloying it. Furthermore, as a gate electrode, a 300 nm-thick Au layer was formed. The gate length was 2 µm, and the gate width was 150 µm.

In order to facilitate division into chips, the surface of a *p*-type GaN layer was attached to a holder for polishing, and then with slurry containing SiC abrasives of 30 µm average particle diameter, polishing was carried out until thickness of the GaN substrates decreased from 400 µm to 100 µm. Subsequently, semiconductors composed of a GaN substrate and a III nitride semiconductor layer were divided into chips of 400 µm × 400 µm.

The HEMTs involving Embodiment 23 and 24 were fabricated in the above manner to evaluate yields. Although the yield evaluation method was the same as in the LEDs described above, "ON" resistance was adopted as device characteristics of the HEMTs. The results are set forth in Table VIII. Also in the implementation in which the HEMTs were fabricated as semiconductor devices, spherically processing the GaN substrate surfaces led to high yields. Furthermore, reducing difference in height between the center of, and the edge of, the substrate surfaces enabled obtaining higher yields. Herein, semiconductor device yield in the situation in which the surface of the GaN substrate of Embodiment 23 was employed without spherically processing the surface was some 42 %, which was low by comparison with spherically processing the surface.

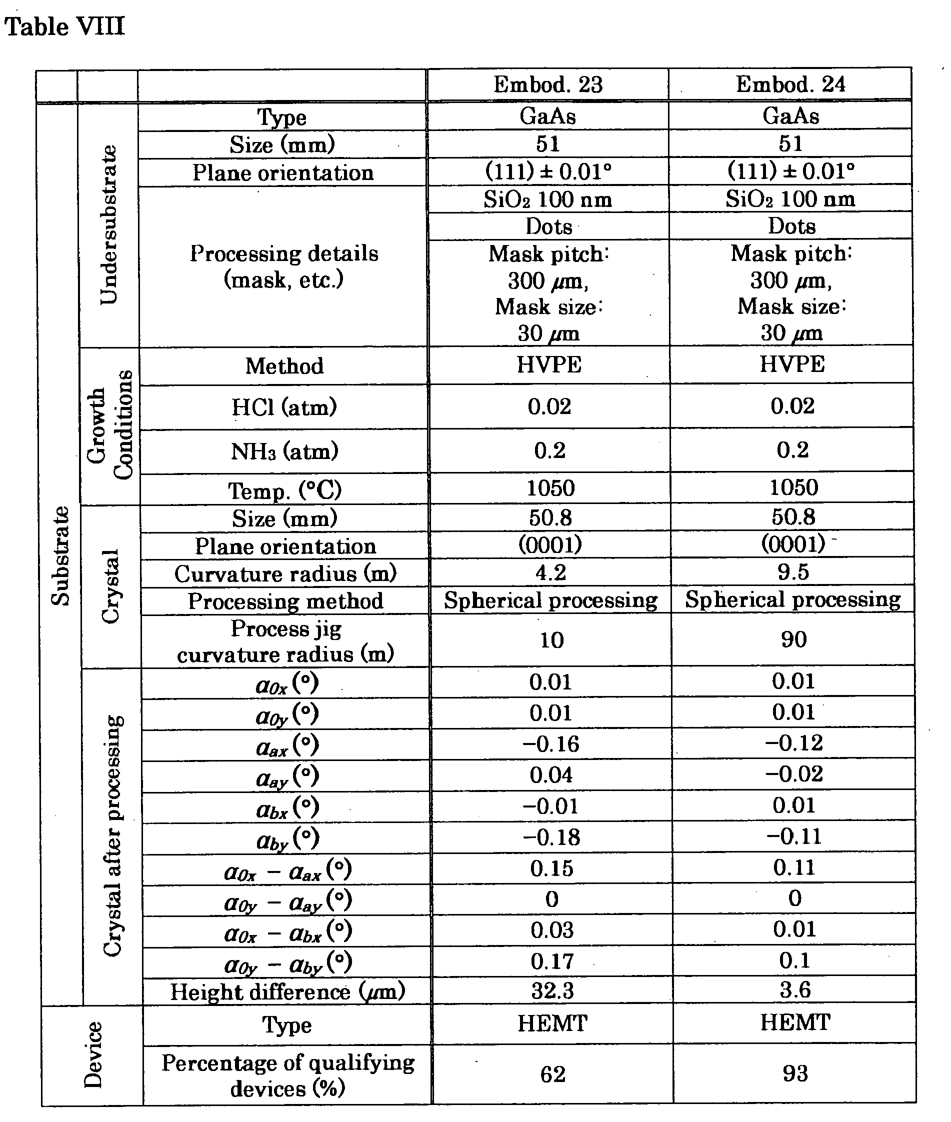

### Embodiments 25 and 26

The GaN substrates fabricated in the manner described above were employed to fabricate, as Embodiments 25 and 26, Schottky diodes that were semiconductor devices 140 involving Embodiment Mode 5 of the present invention. The specific manufacturing method is as follows.

As a III nitride semiconductor layer, a 5 µm-thick *n*⁻-type GaN layer (electron concentration: 1 × 10¹⁶ cm⁻³) was grown onto the 400 µm-thick GaN substrates by MOCVD.

Next, as an ohmic electrode, a composite layer with a Ti layer (50 nm in thickness)/Al layer (100 nm in thickness)/Ti layer (20 nm in thickness)/Au layer (200 nm in thickness) was formed onto the entire back side of the GaN substrates by heating at 800°C for 30 seconds, and alloying it. Furthermore, as a Schottky electrode, an Au layer of 200 µm in diameter × 300 µm in thickness was formed onto the *n*⁻-type GaN layer by photolithography and liftoff techniques.

In order to facilitate division into chips, the surface of a *p*-type GaN layer was attached to a holder for polishing, and then with slurry containing SiC abrasives of 30 µm average particle diameter, polishing was carried out until thickness of the GaN substrates decreased from 400 µm to 100 µm. Subsequently, semiconductors composed of a GaN substrate and a III nitride semiconductor layer were divided into chips of 400 µm × 400 µm.

The Schottky diodes involving Embodiment 25 and 26 were fabricated in the above manner to evaluate yields. Although the yield evaluation method was the same as in the LEDs described above, "ON" resistances were adopted as device characteristics of the Schottky diodes. The results are set forth in Table IX. Also in the implementation in which the Schottky diodes were fabricated as semiconductor devices, spherically processing the GaN substrate surfaces led to high yields. Furthermore, reducing difference in height between the center of, and the edge of, the substrate surfaces enabled obtaining higher yields. Herein, yield in the situation in which the surface of the GaN substrate of Embodiment 25 was employed without spherically processing the surface was some 37 %, which was low by comparison with spherically processing the surface.

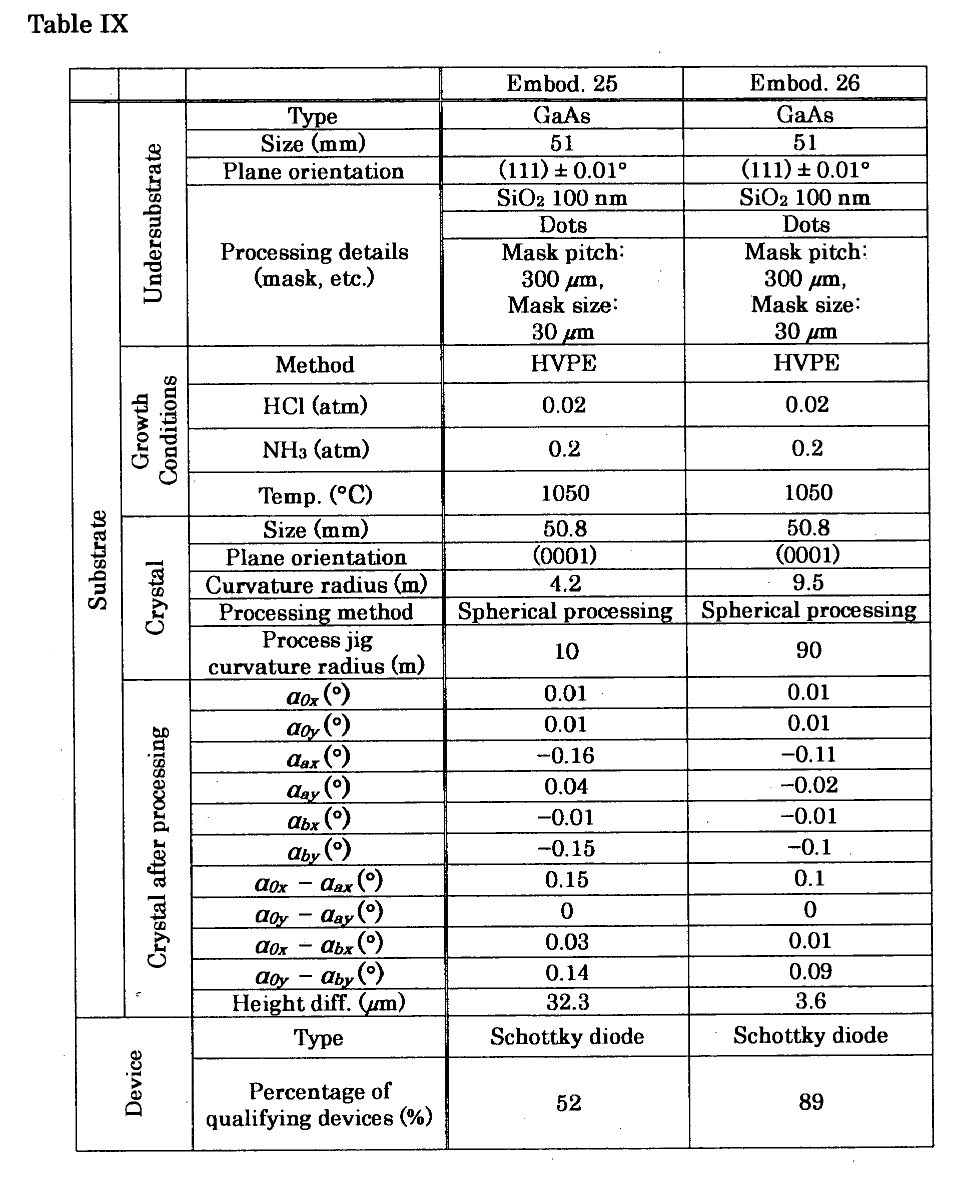

### Embodiments 27 and 28

The GaN substrates fabricated by the method described above were employed to fabricate, as Embodiments 27 and 28, MIS transistors that were semiconductor devices 150 involving Embodiment Mode 6 of the present invention. The specific manufacturing method is as follows.

As an at least single-lamina III nitride semiconductor layer, a 5 µm-thick *n*⁻-type GaN layer (electron concentration: 1 × 10¹⁶ cm⁻³) was grown onto the surfaces of the 400 µm-thick GaN substrates by MOCVD.

Next, a *p*-type GaN layer and an *n*⁺-type GaN layer were formed by selective ion implantation technique. Herein, the *p*-type GaN layer was formed by Mg ion implantation, and the *n*⁺-type GaN layer was formed by Si ion implantation. Subsequently, as a protective film, a 300 nm-thick SiO₂ film was formed onto the III nitride semiconductor layer, and then annealing was carried out at 1250°C for 30 seconds to activate implanted ions. After the activation, the protective film was separated with hydrofluoric acid, and then a 50 nm-thick SiO₂ film was formed as an insulating film for MIS by plasma-enhanced chemical vapor deposition (P-CVD).

Next, a part of the insulating film for MIS was etched by photolithography, and by selective etching in which buffered hydrofluoric acid was employed, and as a source electrode, by liftoff technique, a composite layer with a Ti layer (50 nm in thickness)/Al layer (100 nm in thickness)/Ti layer (20 nm in thickness)/Au layer (200 nm in thickness) was formed onto the etched part by heating at 800°C for 30 seconds, and alloying it. Subsequently, a 300 nm-thick Al layer was formed as a gate electrode onto the insulating film for MIS by photolithography and liftoff to form an MIS structure.

In order to facilitate division into chips, the surface of the *p*-type GaN layer was attached to a holder for polishing, and then with slurry containing SiC abrasives of 30 µm average particle diameter, polishing was carried out until thickness of the GaN substrates decreased from 400 µm to 100 µm. Next, semiconductors composed of a GaN substrate and III nitride semiconductor layer were divided into chips of 400 µm × 400 µm. Onto the entire back side of a GaN substrate in each of the divided chips, as a drain electrode, a composite layer with a Ti layer (50 nm in thickness)/Al layer (100 nm in thickness)/Ti layer (20 nm in thickness)/Au layer (200 nm in thickness) was formed by heating at 800°C for 30 seconds, and alloying it.

The MIS transistors involving Embodiment 27 and 28 were fabricated in the above manner to evaluate yields. Although the yield evaluating method was the same as in the LEDs described above, "ON" resistances were adopted as device characteristics of the MIS transistors. The results are set forth in Table X. Also in the implementation in which the MIS transistors were formed as semiconductor devices, spherically processing the GaN substrate surfaces led to high yields. Furthermore, reducing difference in height between the center of, and the edge of, the substrate surfaces enabled obtaining higher yields. Herein, yield in the situation in which the surface of the GaN substrate of Embodiment 27 was employed without spherically processing the surface was some 21 %, which was low by comparison with spherically processing the surface.

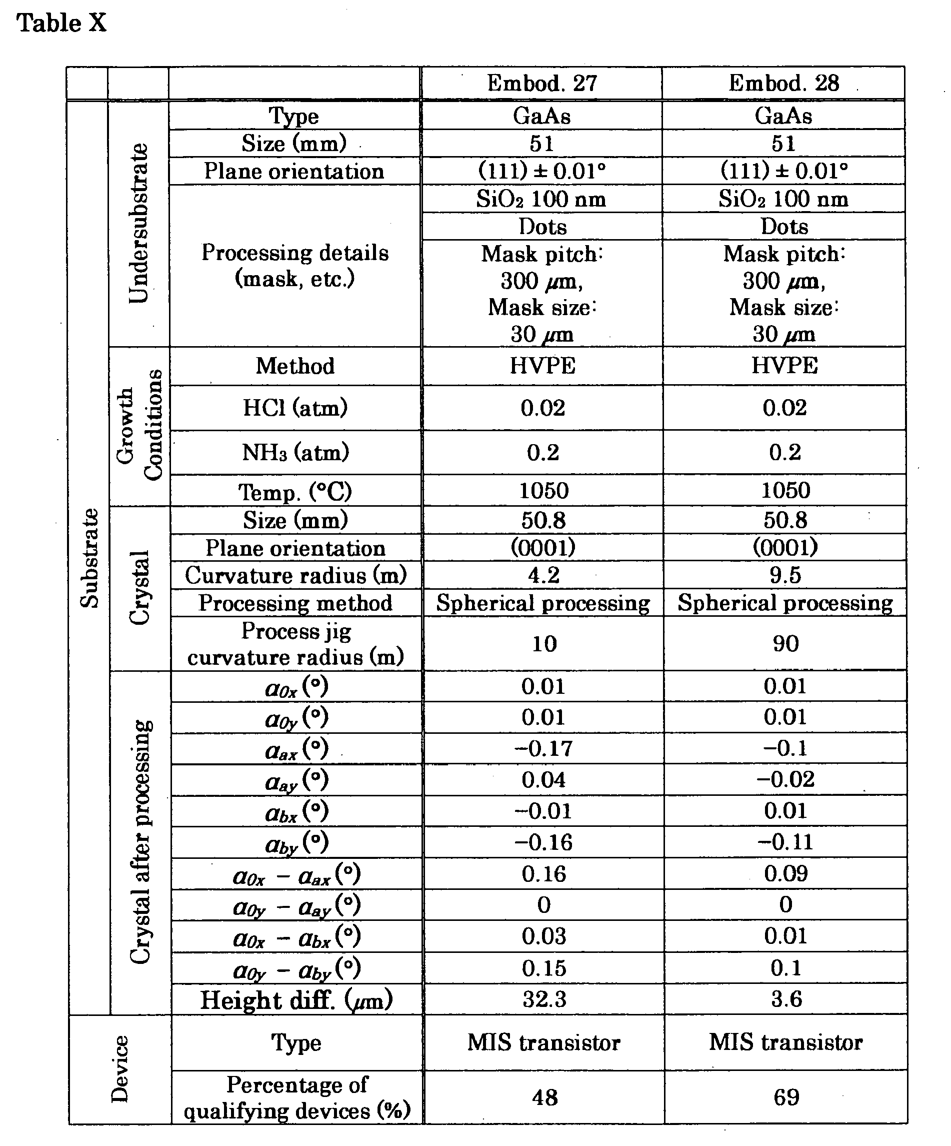

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A method of manufacturing a GaN substrate, **characterized in** including a step of processing the surface of a substrate composed of a GaN single crystal into a concavely spherical form, based on differences in orientation of the crystallographic axis across the substrate surface.

2. A GaN substrate manufacturing method as set forth in claim 1, **characterized in that** in said processing step, the substrate is processed so that across the substrate surface, at other points further inward than 5 mm from the edge face, the difference between the maximum and minimum angles formed by a line normal to the substrate surface and the crystallographic axis is brought to 0.25° or less.

3. A GaN substrate manufacturing method as set forth in claim 1 or claim 2, **characterized in that** in said processing step, the substrate is processed so that across the substrate surface, the difference between the center height and the edge-portion height along the direction normal to the center of the substrate is brought to 22 µm or less.

4. A GaN substrate composed of a single crystal, the GaN substrate **characterized in that** the substrate surface is processed into a concavely spherical form, based on differences in orientation of the crystallographic axis along the substrate surface.

5. A GaN substrate as set forth in claim 4, **characterized in that** across the GaN substrate surface, at other points further inward than 5 mm from the edge face, the difference between the maximum and minimum angles formed by a line normal to the substrate surface and the crystallographic axis is 0.25° or less.

6. A GaN substrate as set forth in claim 4 or claim 5, **characterized in that** across the substrate surface, the difference between the center height and the edge-portion height along the direction normal to the center of the substrate is 22 µm or less.

7. A semiconductor device, **characterized in** comprising:
a basal portion utilizing a portion of a GaN substrate as set forth in any of claims 4 through 6; and
a semiconductor layer deposited onto the surface of the basal portion.

8. A semiconductor device as set forth in claim 7, **characterized in that** the semiconductor device is any one of an LED, an LD, an HEMT, a Schottky diode, or an MIS transistor.
